# EUROPEAN PATENT APPLICATION

(11) **EP 4 852 648 A1**
(43) Date of publication of application: **09.12.2026**
(21) Application number: 25180957.0
(22) Date of filing: 05.06.2025
(51) Int. Cl.: H10D 84/01, H10D 30/00, H10D 64/01, H10D 64/27, H10D 84/83, H10D 84/85, H10D 88/00, H10D 84/03

(54) **A METHOD FOR FABRICATING A SEMICONDUCTOR STRUCTURE**

(71) Applicant: IMEC VZW, 3001 Leuven (BE)
(72) Inventor: MERTENS, Hans, 3000 Leuven (BE); ARIMURA, Hiroaki, 3000 Leuven (BE); TOLEDO DE CARVALHO CAVALCANTE, Camila, 1190 Forest (BE)
(74) Representative: AWA Sweden AB

(57) **Abstract**

A method for fabricating a semiconductor structure (1), the method comprising
providing a layer stack (10)
forming a first sacrificial gate (21) extending up to a level (20), the level being within a vertical extent (24) of the isolation layer (2) of the layer stack;
forming, a dielectric member (50) arranged at the level (20) and extending horizontally at a side of the layer stack (10);
forming, subsequent to forming the dielectric member (50), an opening (54), the opening (54) being formed by removing at least part of the dielectric member (50), such that the first (34) and second (44) gate metals of the first layer stack (10a) are electrically connected via the opening (54).

## Description

### TECHNICAL FIELD

The present inventive concept relates, in general, to a method for fabricating a semiconductor structure.

### BACKGROUND

Modern semiconductor integrated circuit technology includes various types of field-effect transistors (FETs). A FET generally comprises at least one channel extending horizontally between a source and a drain, the at least one channel comprising a semiconductor. Further, the FET generally comprises a gate for controlling a current through the at least one channel.

One notable example of a FET is the nanosheet FET (NSFET). The NSFET comprises at least one channel, in the form of a nanosheet, extending horizontally between a source and a drain. The gate of the NSFET may extend around each channel to form a gate-all-around (GAA).

Another notable example of a FET is a stack of NSFETs comprising at least a first and a second NSFET, the first NSFET being stacked on top of the second NSFET. An example is the so-called complementary FET (CFET), wherein one NSFET of the stack of NSFETs is p-type and the other is n-type.

### SUMMARY

It is an objective of the present inventive concept to facilitate a high-quality transistor system, such as a high-quality stack of NSFETs or a high-quality integrated circuit. It is an objective to facilitate a transistor system comprising transistors with different threshold voltages, i.e. it is an objective to facilitate multi threshold voltage technologies. It is an objective to facilitate a compact transistor system, such as a transistor system with a narrow gate width. It is a further objective to facilitate easy and/or low-cost manufacturing of a transistor system.

These and other objectives of the inventive concept are at least partly met by the invention as defined in the independent claims. Preferred embodiments are set out in the dependent claims.

According to a first aspect there is provided a method for fabricating a semiconductor structure, the method comprising
providing at least one layer stack comprising:
   a first sub-stack comprising a channel layer sandwiched between two sacrificial layers;
   an isolation layer, being an electrically isolating layer;
   a second sub-stack comprising a channel layer sandwiched between two sacrificial layers;
   wherein layers of the layer stack are stacked vertically, the first sub-stack being arranged above the isolation layer and the second sub-stack being arranged below the isolation layer;
the method further comprising, for each of the at least one layer stacks:
   forming a first sacrificial gate extending up to a level, the level being within a vertical extent of the isolation layer;
   releasing, from above, the channel layer of the first sub-stack by removing the sacrificial layers of the first sub-stack;
   forming, from above, a first gate stack above the level and on the released channel layer of the first sub-stack, the first gate stack comprising a first gate dielectric and a first gate metal;
   removing, from below, the first sacrificial gate;
   releasing, from below, the channel layer of the second sub-stack by removing the sacrificial layers of the second sub-stack;
   forming, from below, a second gate stack below the level and on the released channel layer of the second sub-stack, the second gate stack comprising a second gate dielectric and a second gate metal;
   forming, prior to forming the second gate metal, a dielectric member arranged at the level and extending horizontally at a side of the layer stack;
the method further comprising, for at least a first layer stack of the at least one layer stacks:
   forming, subsequently to forming the dielectric member, an opening, the opening being formed by removing at least part of the dielectric member, such that the first and second gate metals of the first layer stack are electrically connected via the opening.

The semiconductor structure may be a semiconductor structure for manufacturing a stack of NSFETs or a plurality of stacks of NSFETs. Accordingly, the method may be part of the fabrication process for a stack of NSFETs. The method may be the replacement metal gate module in the fabrication process for a stack of NSFETs.

Relative spatial terms such as "above", "below", "top", "bottom", "lower", "vertical", "stacked on top of", are herein to be understood as denoting locations or directions within a frame of reference relative to the layer stack. In particular, the terms may be understood in relation to a normal direction to a substrate on which the at least one layer stack is formed, or equivalently in relation to a bottom-up direction of the stack of NSFETs. Correspondingly, terms such as "lateral" and "horizontal" are to be understood as locations or directions parallel to the substrate.

A first direction may be understood as a direction in which the current of the NSFETs flows. A second direction may be understood as a direction transverse to the first direction. A third direction may be understood as the vertical or bottom-up direction. The first and second directions may be parallel to the substrate. The third direction may be normal to the substrate.

The method comprises both processing from above and from below. Forming something from above may comprise depositing and/or etching from above. Removing something from above may comprise etching, e.g. directional etching, from above. Releasing something from above may comprise etching e.g. non-directional selective etching, from above. Forming removing and releasing from below may be described analogously, mutatis mutandis.

Depositing may be performed directionally or conformally. Conformal deposition may be performed e.g. by atomic layer deposition (ALD). Etching may be performed isotropically (etches uniformly in all directions, e.g. both vertically and horizontally) or anisotropically (etches at different rates in different directions, typically faster in the vertical direction).

In the case where processing from above is followed by processing from below, or vice versa, a so-called wafer flip may be performed. For example, the layer stack (or layer stacks) may be arranged on a substrate which we may call first wafer. After processing the layer stack from above, a second wafer may be bonded to the layer stack from above. The first wafer may subsequently be removed. Thereafter, the layer stack may be processed from below. It should be understood that the second wafer carrying the layer stack may be flipped such that a bottom side of the layer stack faces upwards for the subsequent processing. However, in the frame of reference of the layer stack, the processing is still from below.

In analogy to the above, after processing the layer stack on the second wafer from below, a third wafer may be bonded to the layer stack from below. The second wafer may subsequently be removed. Thereafter, the layer stack may be processed from above. The process may continue with further wafer flips. Any number of wafer flips may be used.

Each layer stack may be seen as a fin comprising a plurality of layers. Each layer stack, e.g. each fin, may comprise two opposing lateral side faces, two opposing lateral end faces, and a top face. Each layer stack, e.g. each fin, may be arranged on the substrate.

Channel layers and sacrificial layers may comprise semiconductor material, such as Si and/or Ge. Channel layers and sacrificial layers may have different compositions. Thereby, selective etching of sacrificial layers is enabled. In particular, channel layers may comprise Si (e.g. solely Si) and sacrificial layers may comprise SiGe.

In accordance with the above, releasing channel layers of a sub-stack may comprise selectively etching the sacrificial layers of said sub-stack.

Channel layers may be referred to as nanosheets. Each sub-stack may comprise one or more channel layers. The channel layers of the first sub stack may become the channel layers of the top NSFET in the finished stack of NSFETs. Similarly, the channel layers of the second sub stack may become the channel layers of the top NSFET in the finished stack of NSFETs.

The isolation layer may comprise a dielectric material, e.g. SiCON, SiCN, SiN, or SiCO. The isolation layer may be referred to as middle dielectric isolation (MDI).

The sacrificial gates discussed in this disclosure may alternatively be referred to as dummy gates. The sacrificial gates may comprise amorphous silicon.

Forming the first sacrificial gate may comprise forming an intermediate sacrificial gate straddling the fin (i.e. extending across the layer stack) and subsequently recessing the intermediate sacrificial gate down to the level.

Thus, forming the first sacrificial gate may comprise:
depositing, from above, sacrificial gate material, such that the sacrificial gate material straddles the layer stack;
recessing, from above, the sacrificial gate material down to the level.

Gate spacers on opposite sides of the intermediate sacrificial gate may be formed prior to recessing the intermediate sacrificial gate. The region between the gate spacers may be referred to as a gate trench, wherein the gate trench is first filled by the intermediate sacrificial gate and later filled by the first and second gate stack.

As mentioned, the level, up to which the first sacrificial gate extends, is within a vertical extent of the isolation layer. Phrased differently, the level is within the thickness of isolation layer. In other words, the level may be at a height above a bottom level of the isolation layer and below a top level of the isolation layer. The top level of the isolation layer may be the level coinciding with the top surface of the isolation layer. Similarly, the bottom level of the isolation layer may be the level coinciding with the bottom surface of the isolation layer.

As mentioned, the first gate stack is formed above the level and on the released channel layer of the first sub-stack. The first gate stack may be formed around the released channel layer of the first sub-stack. Thus, the first gate stack may form a GAA for the first (top) NSFET of a stack of NSFETs to be fabricated. The first gate stack comprises a first gate dielectric and a first gate metal. The first gate dielectric may be a high-k dielectric (e.g. a dielectric with a higher dielectric constant than SiO₂). The first gate dielectric may particularly advantageously comprise HfO₂ and/or HfZrO. The first gate metal may comprise a gate work function metal (WFM).

Similarly, the second gate stack is formed below the level and on the released channel layer of the second sub-stack. The second gate stack may be formed around the released channel layer of the second sub-stack. Thus, the second gate stack may form a GAA for the second NSFET of a stack of NSFETs. The second gate stack comprises a second gate dielectric and a second gate metal. The second gate dielectric may be a high-k dielectric (e.g. a dielectric with a higher dielectric constant than SiO₂). The second gate dielectric may particularly advantageously comprise HfO₂ and/or HfZrO. The second gate metal may comprise a WFM.

A gate work function metal is a metal used to control the threshold voltage of a transistor. As will be discussed further below, the WFM of the first gate metal may be different from the WFM of the second gate metal.

Forming a gate stack (e.g. first or second gate stack) may comprise forming the gate dielectric (e.g. by conformal deposition) and subsequently forming the gate metal (e.g. by conformal deposition). However, the gate metal may not necessarily be formed immediately after the gate dielectric. Other steps may be performed in between.

In addition to the WFM, the threshold voltage may be controlled by a dipole shifter. In particular, the dipole shifter may fine tune the threshold voltage. The dipole shifter may be a dipole layer at the interface between the gate dielectric and the gate metal. The dipole shifter may be formed by depositing material comprising dipole formation metals on the gate dielectric and diffuse the dipole formation metals into the gate dielectric. The anneal may be called drive-in anneal or diffusion anneal. Dipole formation metals may be e.g. Lanthanum (La) or Aluminium (Al). Material comprising dipole formation metals may be La₂O₃ or Al₂O₃. Thus, a layer comprising La₂O₃ or/and Al₂O₃ may be deposited on the gate dielectric followed by a subsequent anneal. The anneal may be performed prior to the deposition of the WFM. A dipole shifter may be used for the first gate stack and/or the second gate stack.

The dielectric member may be seen as a gate dielectric layer suitable to separate the top and bottom gates of the NSFETs in a stack of NSFETS. It is a realization that in a transistor system, such as an integrated circuit, comprising several stacks of NSFETs, some stacks of NSFETs may have a common gate for the first and second NSFET while some stacks of NSFETs have separate gates for the first and second NSFET. For the stacks of NSFETs with separate gates, the dielectric member may be preserved during fabrication. For the stacks of NSFETs with common gates, at least part of the dielectric member may be removed (as described above) to form the opening through which the first and second gate metals are electrically connected.

The dielectric member may be formed from above or from below. Part of the dielectric member may be formed from above and another part may be formed from below.

As an example, a part of the dielectric member (or the whole dielectric member) may be formed from above after releasing the at least one channel layer of the first sub-stack and prior to forming the first gate metal.

As another example, a part of the dielectric member (or the whole dielectric member) may be formed from below after releasing the at least one channel layer of the second sub-stack and prior to forming the second gate metal.

The part of the dielectric member being removed to form the opening may be removed from below or from above. The part of the dielectric member being removed to form the opening may be removed prior to forming the second gate metal or prior to forming the first gate metal.

The dielectric member may comprise any dielectric material. The dielectric member may comprise a high-k dielectric (e.g. a dielectric with a higher dielectric constant than SiO₂). The dielectric member may particularly advantageously comprise HfO₂ and/or HfZrO.

The method enables a number of advantages.

It is a realization that the combination of processing steps performed from above and below, according to the method, facilitates a high-quality transistor system.

The method facilitates material combinations for the first and second gate stack that are not possible or at least hard to implement with conventional methods. In particular, the method facilitates the use of different WFMs for the first and second gate stack. Thus, multi threshold voltage technologies are facilitated.

The method further facilitates annealing sequences for the first and second gate stack that are not possible or at least hard to implement with conventional methods.

The method further facilitates easy and/or cost-effective fabrication of stacks of NSFETs. For example, it is a realization that conventional fabrication (e.g. fabrication solely from above) may require multiple spin on carbon (SOC) recess steps. The present method enables fabrication without (or at least with fewer) SOC recess steps. In particular, the method further facilitates easy and/or cost-effective fabrication of narrow gate width devices.

The method facilitates narrow gate widths for the first and second gate stack. Thereby, the method facilitates a compact stack of NSFETs.

It is a further realization that forming the dielectric member and removing at least part of the dielectric member, according to the method, facilitates a system of stacks of NSFETs comprising both stacks of NSFETs with common and separate gates.

It is a further realization that the dielectric member may simplify the fabrication process, e.g. by acting as an etch stop during fabrication (e.g. as an etch stop during removal of the first sacrificial gate).

In accordance with the advantages listed above, a gate work function metal of the first gate metal may be different from a gate work function metal of the second gate metal. The WFM of the first gate metal may be a p-type WFM and the WFM of the second gate metal may be a n-type WFM, or vice versa. Thus, a p-type NSFET on top of a n-type NSFET is facilitated. Examples of n-type WFMs that may be used are TiAl or TiAlC. Examples of p-type WFMs that may be used are TiN or TaN.

Further in accordance with the advantages listed above, the method may be configured such that for each layer stack:
the first sacrificial gate, the first gate stack and the second gate stack are formed in a gate trench, the gate trench extending across the layer stack, the gate trench having a width below 15 nm.

The above is an example of a narrow gate trench, which results in a narrow gate width device. As mentioned above, the gate trench may be the region between the gate spacers.

Said gate trench may extend across the layer stack (e.g. across the fin) in a direction orthogonal to the direction of the current in the finished device. Said gate trench may have a width below 15 nm in the direction of the current in the finished device.

The method may be particularly advantageous for narrow gate width devices. For example, multiple spin on carbon recess steps in a narrow gate trench may be avoided. The method may be further advantageous in the case where the gate trench has a width below 10 nm.

Further in accordance with the advantages listed above, the at least one layer stack may further comprise a second layer stack, laterally adjacent to the first layer stack;
the method may further comprise, for the second layer stack:
preserving the dielectric member of the second layer stack, such that the first and second gate metals of the second layer stack are electrically isolated by the dielectric member of the second layer stack.

Thus, the first layer stack may be used to form a first stack of NSFETs wherein the first and second NSFET of the first stack of NSFETs have a common gate. The second layer stack may be used to form a second stack of NSFETs wherein the first and second NSFET of the second stack of NSFETs have separate gates.

The first- and second-layer stacks may be arranged side by side on the same substrate. Preserving the dielectric member of the second layer stack may comprise masking the dielectric member of the second layer stack prior to forming the opening in the dielectric member of the first layer stack.

In the following, the dielectric member will be discussed further.

At least part of the dielectric member may be formed by a same dielectric deposition as the first or second gate dielectric.

As a first example, a part of the dielectric member or the whole dielectric member may be formed by the dielectric deposition of the first gate dielectric. The dielectric deposition of the first gate dielectric may be a conformal deposition, e.g. an ALD deposition, around the released channel layer of the first sub-stack and on the top surface of the first sacrificial gate.

As a second example, a part of the dielectric member or the whole dielectric member may be formed by the dielectric deposition of the second gate dielectric. The dielectric deposition of the second gate dielectric may be a conformal deposition, e.g. an ALD deposition, around the released channel layer of the second sub-stack and at the level.

The dielectric member may comprise a first layer, the first layer being formed by the same dielectric deposition as the first gate dielectric. The dielectric member may comprise a second layer, the first layer being formed by the same dielectric deposition as the second gate dielectric. Thus, the dielectric member may comprise solely the first layer, solely the second layer, or both the first and second layer. The dielectric member may additionally comprise further layers.

The first layer may be deposited on the top surface of the first sacrificial gate. The second layer may subsequently be deposited on a bottom side of the first layer, after removal of the first sacrificial gate. Alternatively, e.g. if no first layer is deposited on the top surface of the first sacrificial gate, the second layer may be deposited on a bottom side of the first gate stack.

Having at least part of the dielectric member formed by a same dielectric deposition as the first or second gate dielectric is advantageous as it facilitates easy and/or cost-effective fabrication. Further, a low capacitive coupling between the gates of the first and second gate stacks is enabled for the devices having separate gates. Using both the first and second layer for the dielectric member is further advantageous.

Removal of at least part of the dielectric member of the first layer stack may advantageously be performed in a self-aligned manner. Removal of part of the dielectric member will be discussed below.

To exemplify, each layer stack may comprise an etch stop layer arranged below the second sub-stack; and the method may be configured such that
the act of removing at least part of the dielectric member of the first layer stack comprises etching, from below, the dielectric member of the first layer stack and wherein the etch stop layer of the first layer stack masks the second sub-stack of the first layer stack during said etching. Thus, the etching may be performed in a self-aligned manner, e.g. without the need to form a further mask for the act of removing at least part of the dielectric member of the first layer stack, or without the need for accurate alignment of a further mask. The etch stop layer may comprise a dielectric material, e.g. SiCON, SiCN, SiN, or SiCO. The etch stop layer may further be used as an isolation layer and be referred to as bottom dielectric isolation (BDI).

The act of removing at least part of the dielectric member of the first layer stack may comprise directional etching, e.g. in a vertical direction from below. The etch stop layer of the first layer stack may, during etching, shadow the rest of the first layer stack above and thereby protect the rest of the first layer stack.

The method may further comprise:
forming, from below and prior to etching the dielectric member of the first layer stack, a conformal sacrificial layer, the conformal sacrificial layer being formed by conformal deposition on the second gate dielectric of the first layer stack. Thus, the conformal sacrificial layer may protect the second gate dielectric during the etching of the dielectric member of the first layer stack. In particular, during self-aligned etching, the second gate dielectric may be vulnerable to etch damage. Thus, the protection of the conformal sacrificial layer may complement the shadowing effect of the etch stop layer. The conformal sacrificial layer may comprise titanium.

The method may further comprise, for each layer stack:
shaping the layer stack such that the etch stop layer is wider than the channel layer of the second sub-stack. Thus, the shadowing effect of the etch stop layer may be enhanced. When the etch stop layer is wider than the channel layer, the protective shadow of the etch stop layer may also be wider than the channel layer.

The etch stop layer may e.g. be at least 2 nm wider than the channel layer of the second sub-stack. Such a width may provide sufficient protection for the channel layer above and/or for the second gate dielectric of the first layer stack.

As an alternative to removal of part of the dielectric member in a self-aligned manner, part of the dielectric member may be removed using a mask. A mask may be formed lithographically and the part of the dielectric member which is not masked may be etched.

In at least some situations, it may be advantageous to use a further sacrificial gate, e.g. a second sacrificial gate. The use of a further sacrificial gate enables further alternatives regarding the order of depositing the first and second gate dielectric and the first and second gate metal and/or the order of annealing steps. In particular, the use of a second sacrificial gate enables dividing the fabrication process into a hot part and in a subsequent cold part, wherein the first and second gate metals are formed in the cold part. Thus, the first and second gate metals may be spared from hot processing, e.g. spared from annealing of the first and second gate dielectric. Specifically, the first and second gate metals may be spared from the drive-in anneal associated with the formation of a dipole shifter.

To exemplify, the method may be configured such that, for each layer stack, at least a part of the dielectric member is formed, from above, on the first sacrificial gate;
the method further may comprise, for each layer stack:
forming, from above, a second sacrificial gate on said part of the dielectric member and on the first gate dielectric;
wherein the first gate metal is formed by replacing the second sacrificial gate subsequent to forming the second gate metal.

In the following an example of use of a further sacrificial gate is given:
the part of the dielectric member formed on the first sacrificial gate may be the first layer of the dielectric member, e.g. formed in the same deposition as the first gate dielectric;
the second sacrificial gate may subsequently be formed on the dielectric member and on the first gate dielectric;
a wafer flip may subsequently be performed;
the first sacrificial gate may subsequently be removed;
the second gate dielectric may subsequently be formed. Thus, at this point, both gate dielectrics may be in place before any WFM has been formed. The first gate metal may later be formed by replacing the second sacrificial gate with the first gate metal. For example, as described above, the first gate metal may be formed after the second gate metal.

The method may further comprise:
annealing, in a common annealing step, the first gate dielectric and the second gate dielectric, the common annealing step being performed prior to forming the first and second gate metals. A common annealing step may facilitate an easy and/or cost-effective fabrication process. A common annealing step may reduce requirements on the thermal budget. The common annealing step may be a drive-in anneal of a dipole shifter of the first and/or second gate dielectric. As mentioned before, the common annealing step may be performed prior to depositing the first and second gate metals. Thus, the first and second gate metals may be spared from the common annealing of the first and second gate dielectric.

As an example of a process using a common annealing step, consider the following continuation of the above example of use of a further sacrificial gate:
a third sacrificial gate may be formed subsequent to the formation of the second gate dielectric, the third sacrificial gate being formed on the second gate dielectric;
the common annealing step may subsequently be performed, e.g. after depositing material comprising dipole formation metals on the first and/or second gate dielectric;
the third sacrificial gate may subsequently be replaced by the second gate metal;
the second sacrificial gate may subsequently be replaced by the first gate metal.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.

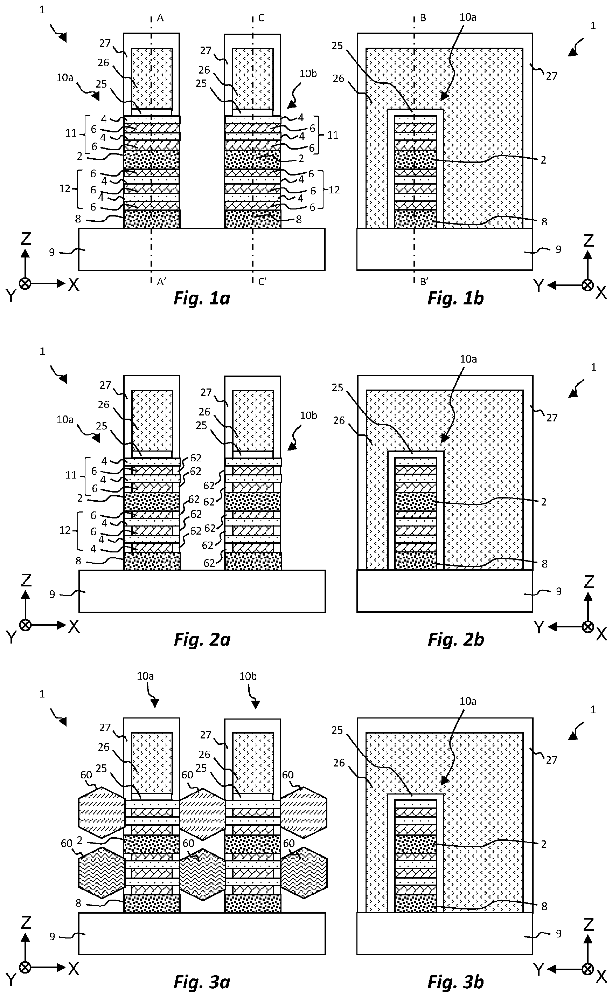

Figure 1-18 illustrate different stages of forming a semiconductor structure comprising stacks of NSFETs.

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

In the drawings, axes X, Y and Z indicate a first direction, a second direction transverse to the first direction, and a third direction, respectively. The X- and Y-direction may in particular be referred to as lateral or horizontal directions in that they are parallel to a main plane of a substrate 9. The Z-direction is parallel to a normal direction to the substrate 9 and may be referred to as the vertical direction. In the drawings, the X-direction corresponds to the direction of the current flow in the finished device.

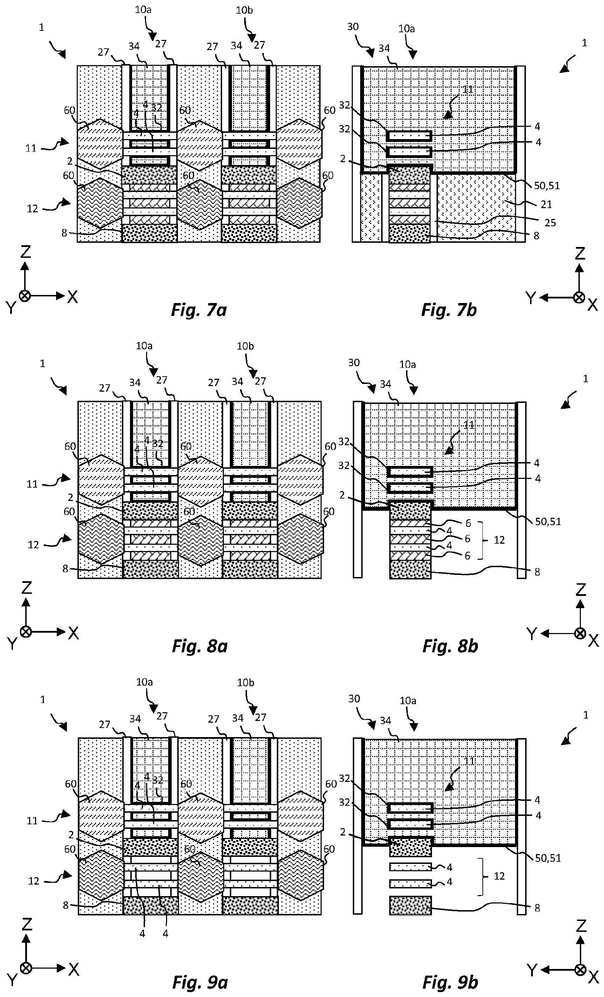

Figs 1-12 illustrates an example of a process flow for fabricating a semiconductor structure 1. In the example, the process flow is performed in the order of Figs 1-12. However, it should be understood that at least some steps may be performed in another order. In the example, the processing steps discussed in conjunction with Figs 1-6 are performed from above. Further, in the example, the processing steps discussed in conjunction with Figs 7-12 are performed from below. However, it should be understood that at least some processing steps may be performed from another direction.

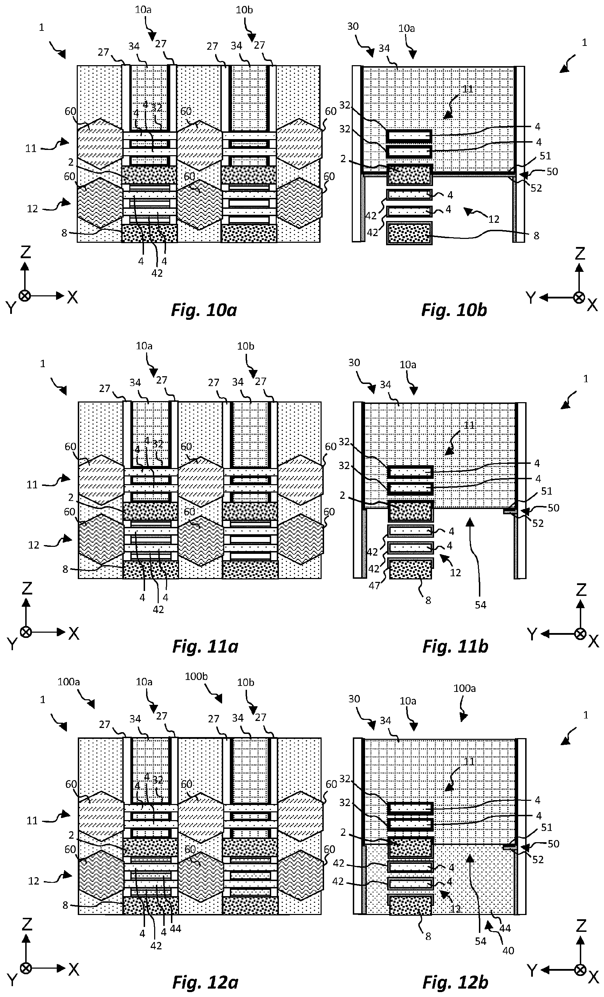

As will be discussed, two layer stacks 10a, 10b are processed into a semiconductor structure 1 comprising a first stack of NSFETs 100a and a second stack of NSFETs 100b. Fig. 1 shows a first 10a and a second 10b layer stack, which are processed to form the respective first 100a and second 100b stack of NSFETs in Fig. 12. Each layer stack 10a, 10b comprises a first 11 and a second 12 sub-stack. In the finished stacks of NSFETs 100a, 100b the channel layers 4 of the first sub-stack 11 are the channel layers 4 of the top NSFET and the channel layers 4 of the second sub-stack 12 are the channel layers 4 of the bottom NSFET.

The a-figures of figures 1-12 are cross-sectional views taken along vertical plane B-B'. The b-figures of figures 1-12 are cross-sectional views taken along vertical plane A-A'.

The B-B' plane is parallel to the XZ-plane and its position is indicated in Fig. 1b. The A-A' plane is parallel to the YZ-plane and its position is indicated in Fig. 1a. As can be seen, the A-A' plane goes through the first layer stack 10a. Thus, the b-figures of figures 1-12 are cross-sectional views of the first layer stack 10a.

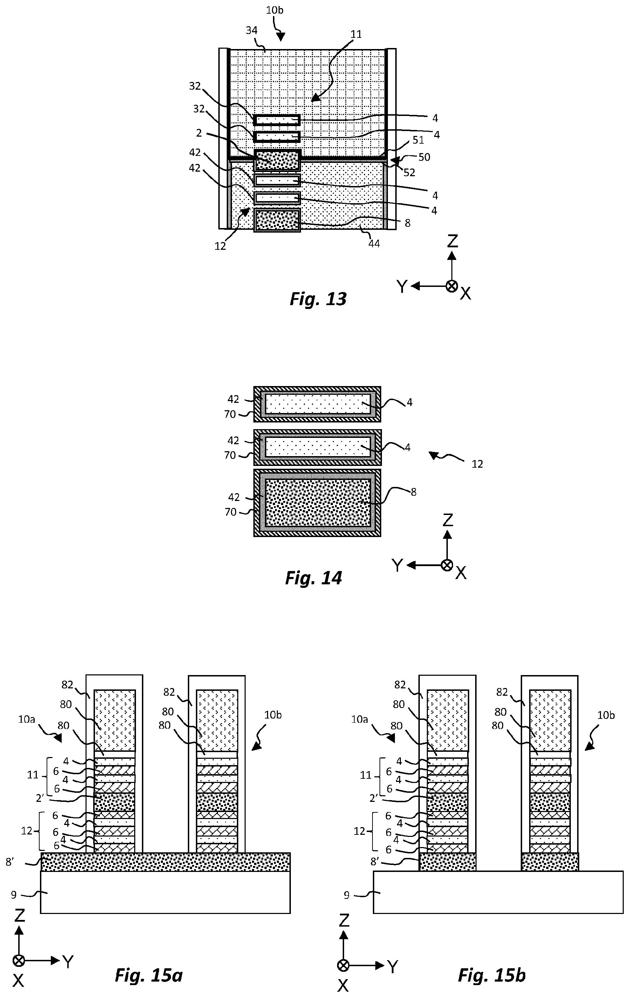

The NSFETS of the first stack of NSFETs 100a (fabricated from layer stack 10a) have a common gate. This is seen in Fig. 12b, where the first 34 and second 44 gate metals of the first layer stack 10a are electrically connected. The fabrication of such a stack of NSFETs with common gate is detailed in conjunction with Figs 1-12. The fabrication of a stack of NSFETs with separate gates, e.g. from the second layer stack 10b, is detailed in conjunction with Fig. 13. Thus, in the following discussion of Figs 1-12, the features of the second layer stack 10b will generally not be discussed. In the following, the features of the second layer stack 10b are identical to the first layer stack 10a, unless otherwise stated.

Fig. 1a illustrates the first 10a and second 10b layer stack provided on the substrate 9. As seen in Fig. 1a, the second layer stack 10b is laterally adjacent to the first layer stack 10a.

Each of the illustrated first 10a and second 10b layer stack comprises: a first sub-stack 11; an isolation layer 2 below the first sub-stack 11; a second sub-stack 12 below the isolation layer 2; an etch stop layer 8 below the second sub-stack 12.

Each illustrated first sub-stack 11 comprises a channel layer 4 sandwiched between two sacrificial layers 6. In the figure, each first sub-stack 11 comprises two channel layers 4.

Each illustrated second sub-stack 12 comprises a channel layer 4 sandwiched between two sacrificial layers 6. In the figure, each second sub-stack 12 comprises two channel layers 4.

Each layer stack 10a, 10b may be seen as a fin comprising a plurality of layers. The layer stacks (fins) may have been etched out of a common set of layers (e.g. prior to the step of Fig. 1a-b).

The substrate 9 may comprise silicon, e.g. be a silicon substrate. Alternatively, the substrate 9 may comprise silicon and a top layer of SiO₂. Thus, there may be a layer of SiO₂ between the layer stacks 10 and the silicon of the substrate 9.

Channel layers 4 and sacrificial layers 6 may comprise semiconductor material, such as Si and/or Ge. In particular, channel layers 4 may comprise Si (e.g. solely Si) and sacrificial layers 6 may comprise SiGe.

The isolation layer 2 may comprise a dielectric material, e.g. SiCON, SiCN, SiN, or SiCO.

The etch stop layer 8 may comprise a dielectric material, e.g. SiCON, SiCN, SiN, or SiCO. The etch stop layer 8 and the isolation layer 2 may comprise the same material.

The isolation layer 2 and/or the etch stop layer 8 may be formed by replacing prior sacrificial layers. Said prior sacrificial layers may be of a different composition than the sacrificial layers 6 of the first 11 and second 12 sub-stacks.

Fig. 1a-b further shows respective intermediate sacrificial gates 26 on the first 10a and second 10b layer stacks. As seen in Fig. 1b, the intermediate sacrificial gate 26 of the first layer stack 10a straddles said first layer stack 10a. The region filled by the intermediate sacrificial gate may, as previously mentioned, be referred to as the gate trench 28. Said gate trench 28 may extend across the layer stack 10 in the Y-direction. Said gate trench 28 may have a width (in the X-direction) below 15 nm. Fig. 1a further shows gate spacers 27 on opposite sides of the respective intermediate sacrificial gates 26. The intermediate sacrificial gates 26 and gate spacers 27 may be used as etch masks during the process of etching out the layer stacks (fins) from the common set of layers. Fig. 1a-b further shows dummy gate oxide 25. As seen in Fig. 1b, the dummy gate oxide 25 of the first layer stack 10a straddles said first layer stack 10a.

The intermediate sacrificial gate 26 may comprise amorphous silicon. The gate spacers 27 may comprise SiCON, SiCN, SiN, or SiCO. The dummy gate oxide 25 may comprise SiO₂.

The layer stacks 10, the intermediate sacrificial gates 26, the gate spacers 27, and the dummy oxide 28 may be formed from above.

Inner spacers 62 may be formed subsequent to providing the layer stacks 10. Fig. 2a-b illustrates the semiconductor structure 1 after formation of inner spacers 62. Inner spacers 62 may be formed by recessing the sacrificial layers 6 along the direction of the X-axis and filling the recesses with a dielectric spacer material, e.g. by ALD followed by an isotropic etch step. The recess may be achieved by a selective and lateral etch back of end surfaces of the sacrificial layers 6. The inner spacers 62 may comprise dielectric material.

Source/drain regions 60 may be formed subsequent to forming the inner spacers 62. Fig. 3a-b illustrates the semiconductor structure 1 after formation of source/drain regions 60. The source/drain regions 60 may be epitaxially grown, e.g. epitaxially grown on end surfaces of the channel layers 4. Source/drain regions 60 connected to channel layers 4 below the isolation layer 2 may have an opposite doping than source/drain regions 60 connected to channel layers 4 above the isolation layer 2. Thus, a CFET may be formed. For example, source/drain regions 60 connected to channel layers 4 below the isolation layer 2 may be n-type, while source/drain regions 60 connected to channel layers 4 above the isolation layer 2 are p-type, or vice versa.

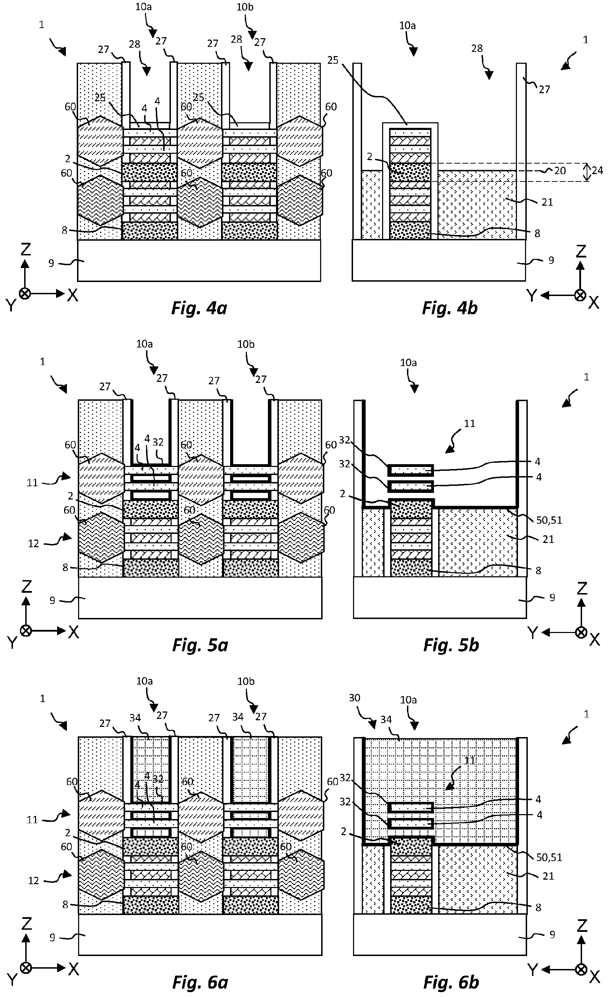

The first sacrificial gate 21 may be formed subsequent to forming source/drain regions 60. Fig. 4a-b illustrates the semiconductor structure 1 after formation of the first sacrificial gate 21. As seen in Fig. 4b, the first sacrificial gate 21 extends up to a level 20, wherein the level 20 is within the vertical extent 24 of the isolation layer 2. In this example, the first sacrificial gate 21 is formed by recessing, from above, the intermediate sacrificial gate 26 down to the level 20. After said recessing, the part of the gate trench 28 above the level may be free to accommodate further depositions, as illustrated.

The channel layers 4 of the first sub-stack 11 may be released subsequent to forming first sacrificial gate 21. The channel layers 4 of the first sub-stack 11 may be released by selective etching of the sacrificial layers 6 of the first sub-stack 11.

The dielectric member 50 may be formed subsequent to releasing channel layers 4 of the first sub-stack 11. Alternatively, the dielectric member 50 may be formed prior to releasing channel layers 4 of the first sub-stack 11.

Further, the first gate dielectric 32 may be formed subsequent to releasing channel layers 4 of the first sub-stack 11.

In the present example, the channel layers 4 of the first sub-stack 11 are released, followed by formation of the first gate dielectric 32 and a first layer 51 of the dielectric member 50 in a common dielectric deposition. Said common dielectric deposition may be a conformal deposition, e.g. by ALD.

Fig. 5a-b illustrates the semiconductor structure 1 after release of the channel layers 4 of the first sub-stack 11 and formation of the dielectric member 50 and the first gate dielectric 32 in a common conformal deposition. In the illustration, the dielectric of the common deposition extends around the released channel layers 4 and on the top surface of the first sacrificial gate 21. In other words, in the illustration, the first gate dielectric 32 extends around the released channel layers 4 and the first layer 51 of the dielectric member 50 is arranged on the top surface of the first sacrificial gate 21.

In the example, the common deposition comprises depositing HfO₂ or HfZrO. However, other dielectric materials are possible.

The first gate metal 34 may be formed subsequent to forming the first gate dielectric 32. Fig. 6a-b illustrates the semiconductor structure 1 after formation of the first gate metal 34. The first gate metal 34 may be formed by conformal deposition, e.g. by ALD. The first gate metal 34 may comprise one or more work function metals (WFM), such as TiN, TaN, TiAl, TiAlC or WCN, or combinations thereof. As illustrated in Fig. 6a-b, the first gate dielectric 32 and the first gate metal 34 forms the first gate stack 30.

In preparation for processing from below, the substrate 9 may be removed. Removal of the substrate 9 may be performed subsequent to forming the first gate metal 34. Fig. 7a-b illustrates the semiconductor structure 1 after removal of the substrate 9. In this example we may refer to the substrate as the first wafer. Prior to removal of the first wafer, a second wafer may be bonded to the semiconductor structure 1. For illustrative purposes the second wafer is not shown in Figs 7-12.

In the following, processing from below will be discussed in conjunction with Figs 8-12.

The first sacrificial gate 21 may be removed from below, subsequent to removing the substrate 9. Fig. 8a-b illustrates the semiconductor structure 1 after removal of the first sacrificial gate 21. The first sacrificial gate 21 may be removed by etching. In Fig. 8a-b, the dummy gate oxide 25 has additionally been removed.

The channel layers 4 of the second sub-stack 12 may be released subsequent to removing first sacrificial gate 21. The channel layers 4 of the second sub-stack 12 may be released by selective etching of the sacrificial layers 6 of the second sub-stack 12. Fig. 9a-b illustrates the semiconductor structure 1 after release of the channel layers 4 of the second sub-stack 12.

The second gate dielectric 42 may be formed subsequent to releasing channel layers 4 of the second sub-stack 12.

Further, part of the dielectric member 50 (or in some cases the entire dielectric member 50) may be formed subsequent to releasing channel layers 4 of the second sub-stack 12. Alternatively, said part of the dielectric member 50 (or full dielectric member 50) may be formed prior to releasing channel layers 4 of the second sub-stack 12.

In the present example, the second gate dielectric 42 and a second layer 52 of the dielectric member 50 are formed in a common dielectric deposition. Said common dielectric deposition may be a conformal deposition, e.g. by ALD.

Fig. 10a-b illustrates the semiconductor structure 1 after release of the channel layers 4 of the second sub-stack 12 and formation of the second layer 52 of the dielectric member 50 and the second gate dielectric 42 in a common conformal deposition. In the illustration, the dielectric of the common deposition extends around the released channel layers 4 and on the bottom surface of the first layer 51 of the dielectric member 50. In other words, in the illustration, the second gate dielectric 42 extends around the released channel layers 4 and the second layer 52 of the dielectric member 50 is arranged where the top surface of the first sacrificial gate 21 previously were.

In the example, the common deposition comprises depositing HfO₂ or HfZrO. However, other dielectric materials are possible.

The opening 54 may be formed subsequent to forming the second gate dielectric 42 (e.g. in the case where part of the dielectric member is formed in the same deposition as the second gate dielectric 42). Fig. 11a-b illustrates the semiconductor structure 1 after forming the opening 54 for the first layer stack 10a. The opening 54 may be formed by etching, e.g. from below or from above, part of the dielectric member 50 (or the entire dielectric member 50).

In the present example, each layer stack 10 comprises an etch stop layer 8. Thus, the etching of the dielectric member 50 may be performed in a self-aligned manner. The etch may be directional. The etch stop layer 8 of the first layer stack 10a may, during etching, shadow the rest of the first layer stack 10a above and thereby protect the rest of the first layer stack 10a. This is seen in Fig. 11a-b, wherein dielectric material 47 on the bottom side of the etch stop 8 has been affected by the etch of the dielectric member 50 but the second gate dielectric 42 on the above channel layers is at least largely unaffected by the etch. The protection of the second gate dielectric 42 may be further enhanced, as will be discussed in conjunction with Figs 14 and 15.

The second gate metal 44 may be formed subsequent to forming the opening 54. Fig. 12a-b illustrates the semiconductor structure 1 after formation of the second gate metal 44. The second gate metal 44 may be formed by conformal deposition, e.g. by ALD. The second gate metal 44 may comprise one or more work function metals (WFM), such as TiN, TaN, TiAl, TiAlC or WCN, or combinations thereof. As illustrated in Fig. 12a-b, the second gate dielectric 42 and the second gate metal 44 forms the second gate stack 40. The gate work function metal of the first gate metal 34 may be different from a gate work function metal of the second gate metal 44. As seen in Fig. 12b, the first 34 and second 44 gate metals of the first layer stack 10a are electrically connected via the opening 54.

As previously discussed, the semiconductor structure 1 of Fig. 12a may be seen as comprising a first stack of NSFETs 100a, fabricated from the first layer stack 10a, and a second stack of NSFETs 100b, fabricated from the second layer stack 10b. The top and bottom NSFETs of the first stack of NSFETs 100a have a common gate due to the opening 54, as seen in the cross-sectional view of the first layer stack 10a in Fig. 12b.

As previously discussed, the top and bottom NSFETs of the second stack of NSFETs 100b may have separate gates. Fig. 13 illustrates a cross-sectional view of the second layer stack 10b in such a case. Fig. 13 is a cross-sectional view taken along vertical C-C' plane. The C-C' plane is parallel to the YZ-plane and its position is indicated in Fig. 1a. Fig. 13 may be seen as a cross-sectional view of the second layer stack 10b at the same point in the fabrication process as Fig. 12a-b.

In Fig. 13 there is no opening in the dielectric member 50 of the second layer stack 10b. Thus, the first 34 and second 44 gate metals of the second layer stack 10b are electrically isolated by the dielectric member 50 of the second layer stack 10b. Such a structure may be formed by preserving the dielectric member 50 of the second layer stack 10b. Preserving the dielectric member 50 of the second layer stack 10b may comprise masking the dielectric member 50 of the second layer stack 10b prior to forming the opening 54 in the dielectric member 50 of the first layer stack 10a. For example, prior to the steps discussed in conjunction with Fig. 11a-b, a mask may be applied from below to protect the dielectric member 50 of the second layer stack 10b during the etching of the dielectric member 50 of the first layer stack 10a.

In the following, ways to enhance the protection of the second gate dielectric 42 of the first layer stack 10a during formation of the opening 54 will be discussed in conjunction with Figs 14 and 15.

Fig. 14 illustrates the second sub-stack 12 of the first layer stack 10a after formation of the second gate dielectric 42 and prior to forming the opening 54 in the dielectric member 50. In Fig. 14, a conformal sacrificial layer 70 has been formed on the second gate dielectric 42 of the first layer stack 10a. The conformal sacrificial layer 70 is formed by conformal deposition, e.g. by ALD. The conformal sacrificial layer may comprise titanium. During formation of the opening 54 the conformal sacrificial layer 70 may protect the second gate dielectric 42 (e.g. protect lateral sides of the second gate dielectric 42). The etch used to form the opening 54 may etch the conformal sacrificial layer 70 (e.g. lateral sides of the conformal sacrificial layer 70) but not reach the second gate dielectric 42.

Figs 15a-b illustrate shaping of the etch stop layer 8 such that it is wider than the channel layers 4 of the second sub-stack 12. In the figures, the etch stop layer 8 is shaped to be wider than the channel layers 4 of the second sub-stack 12 in the Y-direction. As previously mentioned, the layer stacks (fins) 10 may be formed from a common set of layers. The common set of layers may comprise a first sub-stack 11; an intermediate isolation layer 2' below the first sub-stack 11; a second sub-stack 12 below the isolation layer 2; an intermediate etch stop layer 8' below the second sub-stack 12. The intermediate isolation layer 2' and the intermediate etch stop layer 8' may be sacrificial layers (e.g. sacrificial layers of a different composition than the sacrificial layers 6 of the first 11 and second 12 sub-stack. The intermediate isolation layer 2' and the intermediate etch stop layer 8' may later be replaced by the isolation layer 2 and the etch stop layer 8.

During the etching of the common set of layers, all layers of the layer stacks 10 may be etched except for the intermediate etch stop layer 8'. The layers above the intermediate etch stop layer 8' may subsequently be masked and then the intermediate etch stop layer 8' may be etched to a greater width than the above layers.

Fig. 15a illustrates a first 10a and a second 10b layer stack after etching of the layers above the common intermediate etch stop layer 8'. The etching of the layers above the common intermediate etch stop layer 8' may be performed using one or more top masks 80, as illustrated. Subsequent to said etching, a side mask 82 may be deposited, e.g. by conformal deposition. The side mask 82 may mask side surfaces orthogonal to the Y-direction, as illustrated.

Fig. 15b illustrates the first 10a and second 10b layer stacks after etching also the common intermediate etch stop layer 8'. As seen in Fig. 15b, the intermediate etch stop layer 8' of the respective first 10a and second 10b layer stacks is wider than the channel layers 4. Thus, when the intermediate etch stop layer 8' is replaced by the etch stop layer 8, also the etch stop layer 8 will be wider than the channel layers 4.

During formation of the opening 54, the wide etch stop layer 8 may protect the second gate dielectric 42 (e.g. protect lateral sides of the second gate dielectric 42).

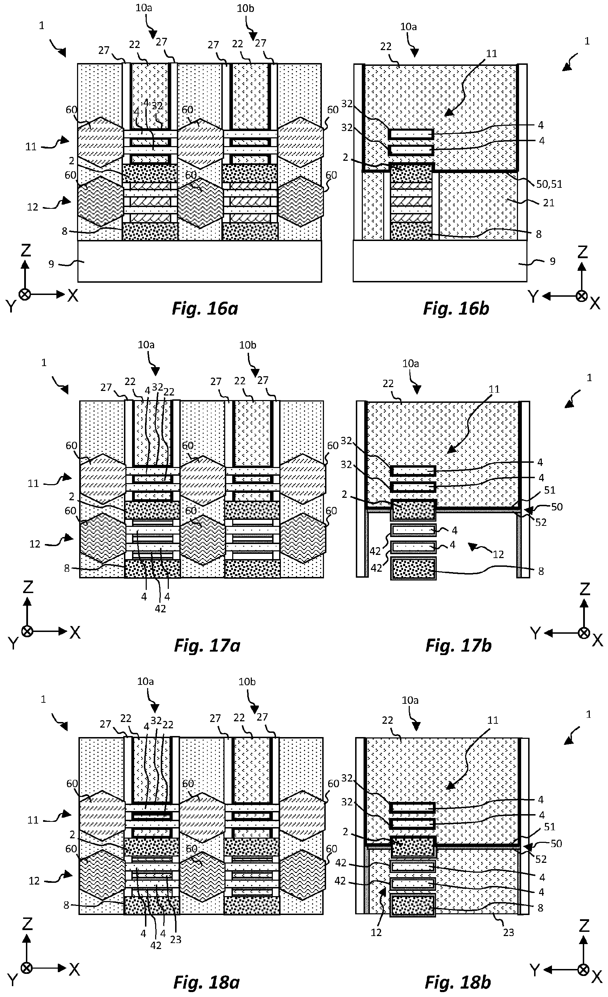

In the following, the use of further sacrificial gates, in addition to the first sacrificial gate 21, will be discussed. Figs. 16-18 illustrate optional processing steps that may be performed after the formation of the first gate dielectric 32. Thus, the optional process of Figs. 16-18 may commence after Fig. 5. In the following example of optional process steps, the process flow is performed in the order of Figs 16-18. The processing discussed in conjunction with Fig. 16 may be performed from above. The processing discussed in conjunction with Figs 17-18 may be performed from below.

The a-figures of figures 16-18 are cross-sectional views taken along vertical plane B-B'. The b-figures of figures 16-18 are cross-sectional views taken along vertical plane A-A'. Thus, the b-figures of figures 16-18 are cross-sectional views of the first layer stack 10a.

Fig. 16a-b illustrates a second sacrificial gate 22 arranged on the dielectric member 50. Thus, at this point of processing the second sacrificial gate 22 may be seen as a placeholder for the first gate metal 34. Thus, the first gate metal 34 may be formed later in the process flow. The second sacrificial gate 22 may comprise amorphous silicon. The second sacrificial gate 22 may be formed subsequent to forming the dielectric member 50. The second sacrificial gate 22 may be formed from above.

The first sacrificial gate 21 may be removed from below, subsequent to forming the second sacrificial gate 22. The channel layers 4 of the second sub-stack 12 may be released subsequent to removing first sacrificial gate 21. The second gate dielectric 42 may be formed subsequent to releasing channel layers 4 of the second sub-stack 12. Fig. 17a-b illustrates the semiconductor structure 1 after removal of the first sacrificial gate 21, release of the channel layers 4 of the second sub-stack 12, and formation of the second gate dielectric 42. The processing may be similar to the processing discussed in conjunction with Figs 8-10, albeit with the second sacrificial gate 22 acting as placeholder for the first gate metal 34.

A third sacrificial gate 23 may be formed from below. The third sacrificial gate 23 may be formed subsequent to forming the second gate dielectric 42. The third sacrificial gate 23 may be formed on the second gate dielectric 42. Fig. 18a-b illustrates the semiconductor structure 1 after formation of the third sacrificial gate 23 on the second gate dielectric 42. Thus, at this point of processing, the third sacrificial gate 23 may be seen as a placeholder for the second gate metal 44.

The structure may subsequently be subjected to annealing, e.g. subjected to a drive-in anneal after which the second 22 and third 23 sacrificial gates may be replaced by the first 34 and second 44 gate metals, respectively. Thus, in the above example, the first gate dielectric 32 and the second gate dielectric 42 are subjected to a common annealing step prior to forming the first 34 and second 44 gate metals.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for fabricating a semiconductor structure (1), the method comprising
providing at least one layer stack (10) comprising:
a first sub-stack (11) comprising a channel layer (4) sandwiched between two sacrificial layers (6);
an isolation layer (2), being an electrically isolating layer;
a second sub-stack (12) comprising a channel layer (4) sandwiched between two sacrificial layers (6);
wherein layers of the layer stack (10) are stacked vertically, the first sub-stack (11) being arranged above the isolation layer (2) and the second sub-stack (12) being arranged below the isolation layer (2);
the method further comprising, for each of the at least one layer stacks (10):
forming a first sacrificial gate (21) extending up to a level (20), the level being within a vertical extent (24) of the isolation layer (2);
releasing, from above, the channel layer (4) of the first sub-stack (11) by removing the sacrificial layers (6) of the first sub-stack (11);
forming, from above, a first gate stack (30) above the level (20) and on the released channel layer (4) of the first sub-stack (11), the first gate stack (30) comprising a first gate dielectric (32) and a first gate metal (34);
removing, from below, the first sacrificial gate (21);
releasing, from below, the channel layer (4) of the second sub-stack (12) by removing the sacrificial layers (6) of the second sub-stack (12);
forming, from below, a second gate stack (40) below the level (20) and on the released channel layer (6) of the second sub-stack (12), the second gate stack (40) comprising a second gate dielectric (42) and a second gate metal (44);
forming, prior to forming the second gate metal (44), a dielectric member (50) arranged at the level (20) and extending horizontally at a side of the layer stack (10);
the method further comprising, for at least a first layer stack (10a) of the at least one layer stacks (10):
forming, subsequently to forming the dielectric member (50), an opening (54), the opening (54) being formed by removing at least part of the dielectric member (50), such that the first (34) and second (44) gate metals of the first layer stack (10a) are electrically connected via the opening (54).

2. The method of claim 1, wherein the at least one layer stack (10) further comprises a second layer stack (10b), laterally adjacent to the first layer stack (10a);
the method further comprising, for the second layer stack (10b):
preserving the dielectric member (50) of the second layer stack (10b), such that the first (34) and second (44) gate metals of the second layer stack (10b) are electrically isolated by the dielectric member (50) of the second layer stack (10b).

3. The method of claim 1 or 2, wherein a gate work function metal of the first gate metal (34) is different from a gate work function metal of the second gate metal (44).

4. The method of any one of the preceding claims, wherein, for each layer stack (10):
the first sacrificial gate (21), the first gate stack and the second gate stack are formed in a gate trench (28), the gate trench (28) extending across the layer stack (10), the gate trench (28) having a width below 15 nm.

5. The method of any one of the preceding claims, wherein at least part of the dielectric member (50) is formed by a same dielectric deposition as the first (32) or second (42) gate dielectric.

6. The method of claim 5, wherein the dielectric member (50) comprises a first layer (51) and a second layer (52), the first layer (51) being formed by the same dielectric deposition as the first gate dielectric (32) and the second layer (52) being formed by the same dielectric deposition as the second gate dielectric (42).

7. The method of any one of the preceding claims, wherein each layer stack (10) further comprises an etch stop layer (8) arranged below the second sub-stack (12);
wherein said act of removing at least part of the dielectric member (50) of the first layer stack (10a) comprises etching, from below, the dielectric member (50) of the first layer stack (10a) and wherein the etch stop layer (8) of the first layer stack (10a) masks the second sub-stack (12) of the first layer stack (10a) during said etching.

8. The method of claim 7, the method further comprising:
forming, from below and prior to etching the dielectric member (50) of the first layer stack (10a), a conformal sacrificial layer (70), the conformal sacrificial layer (70) being formed by conformal deposition on the second gate dielectric (42) of the first layer stack (10a).

9. The method of claim 7 or 8, the method further comprising, for each layer stack (10):
shaping the layer stack (10) such that the etch stop layer (8) is wider than the channel layer (4) of the second sub-stack (12).

10. The method of claim 9, wherein the etch stop layer (8) is at least 2 nm wider than the channel layer (4) of the second sub-stack (12).

11. The method of any one of the preceding claims, wherein the dielectric member (50) comprises HfO₂ or HfZrO.

12. The method of any one of the preceding claims, wherein forming the first sacrificial gate extending up to the level (20) comprise:
depositing, from above, sacrificial gate material, such that the sacrificial gate material straddles the layer stack (10);
recessing, from above, the sacrificial gate material down to the level (20).

13. The method of any one of the preceding claims, wherein, for each layer stack (10), at least a part of the dielectric member (50) is formed, from above, on the first sacrificial gate (21);
the method further comprising, for each layer stack (10):
forming, from above, a second sacrificial gate (22) on said part of the dielectric member (50) and on the first gate dielectric (32);
wherein the first gate metal (34) is formed by replacing the second sacrificial gate (22) subsequent to forming the second gate metal (44).

14. The method of claim 13, the method further comprising
annealing, in a common annealing step, the first gate dielectric (32) and the second gate dielectric (42), the common annealing step being performed prior to forming the first (34) and second (44) gate metals.
